# FASCICULE DE BREVET EUROPEEN

(11) **EP 0 638 527 B1**
(45) Date de publication et mention de la délivrance du brevet: **03.11.1999**
(21) Numéro de dépôt: 94401845.6
(22) Date de dépôt: 11.08.1994
(51) Int. Cl.: C03C 17/22, C23C 16/34, C01B 21/06, C01B 21/076, C03C 17/34

(54) **Procédé de dépôt d'une couche à base de nitrure de titane sur un substrat transparent**
Verfahren zum Ablegen einer Dünnschicht auf Basis von einem Titannitrid auf einem transparenten Substrat
Process for the deposition of a titanium nitride layer on a transparent substrate

(30) Priorité: 12.08.1993 FR 9309916
(43) Date de publication de la demande: 15.02.1995
(60) Demande divisionnaire: 99107159.8
(73) Titulaire: SAINT-GOBAIN VITRAGE, 92400 Courbevoie (FR)
(72) Inventeur: Boire, Philippe, F-75015 Paris (FR); Testulat, Bertrand, F-95200 Sarcelles (FR)
(74) Mandataire: Renous Chan, Véronique

(56) Documents cités:
- EP-A- 0 425 825
- EP-A- 0 546 670
- WO-A-84/02128
- WO-A-90/09883
- WO-A-93/07099
- DATABASE WPI Week 8718, Derwent Publications Ltd., London, GB; AN 87-126984 & JP-A-62 070 208 (TORAY IND. INC.) 31 Mars 1987
- CHEMICAL ABSTRACTS, vol. 115, no. 24, 16 Décembre 1991, Columbus, Ohio, US; abstract no. 261805t, page 363 ; & JP-A-3 137 039 (ASAHI GLASS COMPANY LTD.) 11 Juin 1991

## Description

L'invention concerne le dépôt d'une couche à base de nitrure métallique sur un substrat transparent, notamment en verre, tout particulièrement en vue de la fabrication de vitrages à propriétés de protection vis-à-vis des rayonnements solaires.

En effet, de tels vitrages, grâce à la présence de couches de nitrure comme le nitrure de titane, permettent de réduire dans un local ou habitacle l'apport thermique dû aux rayonnements solaires, en agissant par absorption et réflexion.

Différentes techniques existent pour réaliser le dépôt de couches de nitrure métallique. Les techniques de dépôt sous vide du type pulvérisation cathodique assistée par champ magnétique donnent de bons résultats et permettent l'obtention de couches de nitrure de composition parfaitement contrôlable, et de colorimétrie satisfaisante, avec notamment une couleur en transmission dans les gris. Mais ces techniques ne peuvent être utilisées que de manière discontinue et nécessitent des appareillages complexes, d'où un coût de fabrication élevé.

Il est également connu d'utiliser des techniques de pyrolyse, notamment en phase gazeuse, également appelées CVD (Chemical Vapor Deposition). Ces techniques consistent, de manière schématique, à amener au contact du substrat porté à haute température des précurseurs métalliques et azotés, qui, sous l'effet de la chaleur, se décomposent à son contact sous forme de nitrure.

Ces techniques présentent l'avantage d'être applicables en continu, directement sur le ruban de verre float, notamment dans l'enceinte même du bain de flottage où le verre est déjà à la température adéquate de pyrolyse, et ceci sans avoir à recourir à des conditions opératoires contraignantes, en terme de pression par exemple.

Le brevet EP-B-0 128 169 décrit ainsi l'obtention de couches de nitrure de titane par pyrolyse en phase gazeuse, à partir d'un précurseur de titane sous forme de tétrachlorure de titane et d'un précurseur azoté sous forme d'ammoniac. Cependant, le procédé décrit impose un contrôle rigoureux des conditions de température dans lesquelles s'effectue le dépôt, afin d'éviter, lorsque les deux précurseurs entrent mutuellement en contact, que ne se forme un produit secondaire de réaction sous forme pulvérulente qui provoque encrassement du dispositif de distribution et éventuellement baisse de la qualité du film de nitrure obtenu par création de piqûres ou voile à sa surface.

Il a été par ailleurs observé qu'utiliser ces deux précurseurs sans se placer dans des conditions opératoires très rigoureuses, notamment en termes de traces d'impuretés, d'humidité ou de composés oxydants du type oxygène dans les dispositifs de distribution ou quand la température de dépôt n'est pas suffisamment élevée, conduisait à l'obtention de couches de nitrure conférant au substrat (type substrat de verre) qu'elles recouvrent une coloration jaune-brune en transmission, et non la coloration grise que l'on obtient par exemple lorsqu'on utilise des techniques de dépôt par pulvérisation cathodique. Cette modification de couleur serait due au fait que la couche de nitrure serait un peu différente, notamment chimiquement et/ou électroniquement, du fait notamment d'une certaine teneur en impuretés ou éléments autres que l'azote ou le métal en question. Or cette couleur jaune ou brune est peu appréciée des architectes du bâtiment, car elle donne une perception très déformée de la couleur du ciel à une personne située à l'intérieur d'un local équipé d'un tel substrat comme vitrage.

Il est en outre connu du brevet US-5 194 642 d'utiliser, toujours pour déposer sur un substrat de verre une couche de nitrure de titane, un unique précurseur organo-métallique contenant à la fois les atomes de titane et d'azote nécessaires. Ce produit, se présentant sous forme pulvérulente est le résultat d'une réaction entre un halogénure de titane et une amine, réaction effectuée en deux étapes, la première à relativement basse température à pression atmosphérique, la seconde sous vide partiel à température beaucoup plus élevée. Il est vraisemblable que le rendement d'une telle réaction n'est pas extrèmement élevé, et il faut compter en plus une étape additionnelle de sublimation de ce précurseur avant de le projeter sur le substrat en verre. L'usage d'un tel précurseur tend donc, globalement, à diminuer le rendement de la pyrolyse par rapport aux deux constituants de départ, à compliquer le procédé de dépôt et à renchérir le coût.

Le but de l'invention est donc de pallier tous ces inconvénients en proposant un autre type de procédé de dépôt en phase gazeuse d'une couche de nitrure de titane, procédé qui conjugue bon rendement, simplicité de mise en oeuvre à l'échelle industrielle et colorimétrie favorable des couches obtenues, tout particulièrement en transmission.

L'invention a pour objet un procédé de dépôt par pyrolyse en phase gazeuse d'une couche à base de nitrure ou oxynitrure de titane, sur un substrat transparent, notamment en verre. Ce procédé consiste à amener simultanément au contact dudit substrat porté à haute température au moins un précurseur métallique et au moins un précurseur azoté sous forme d'amine dans un rapport de l'ordre de 2%. On entend par précurseurs des composés susceptibles de se décomposer en se combinant à haute température.

Ce procédé est tout particulièrement adapté au dépôt de couches de nitrure métallique sur un ruban de verre float, en continu, notamment dans l'enceinte même du bain de flottage.

Le fait de choisir un précurseur azoté sous forme d'amine permet d'obtenir des couches de nitrure conférant à leur substrat porteur transparent une couleur en transmission dans la gamme des bleus, couleur très appréciée des architectes actuellement, notamment dans le domaine du bâtiment. Ce qui est remarquable du procédé selon l'invention, c'est que l'obtention de cette colorimétrie ne nécessite pas de se placer dans des conditions opératoires très strictes, qui seraient difficiles et coûteuses à atteindre à l'échelle industrielle, sur une ligne float par exemple.

La raison pour laquelle la couleur en transmission du substrat porteur est modifiée favorablement lorsqu'on utilise une amine, et non de l'ammoniac, comme précurseur azoté, à conditions opératoires identiques, repose vraisemblablement sur une modification des mécanismes réactionnels mis en jeu lorsque le précurseur azoté et le précurseur métallique entrent en contact à haute température. Les mécanismes sont complexes et non encore parfaitement élucidés, mais il semblerait que, curieusement, l'utilisation d'amine comme précurseur azoté changerait le schéma de rupture des liaisons chimiques au sein du précurseur métallique.

Le choix du précurseur azoté selon l'invention aurait une incidence certaine sur la structure et/ou le taux de constituants mineurs autres que le métal et l'azote dans la couche de nitrure métallique obtenue, et pourrait ainsi dans une certaine mesure en modifier les propriétés et caractéristiques.

Ainsi, il a été observé que la formation de nitrure de titane à partir de tétrachlorure de titane TiCl₄ et d'amine du type méthylamine au lieu d'ammoniac conduisait à une augmentation significative du taux de chlore résiduel dans la couche de nitrure et en modifiait son comportement électrique, notamment en augmentant sa conductivité, et optique.

Par ailleurs, un précurseur aminé a sensiblement moins tendance que l'ammoniac à former avec le précurseur métallique un produit secondaire pulvérulent, ce qui est avantageux car on peut ainsi diminuer la fréquence des nettoyages des dispositifs d'amenée des gaz et préserver la qualité de la couche obtenue, sans diminuer le rendement du procédé.

Le mode de réalisation préféré de l'invention consiste à effectuer le dépôt à l'aide d'une seule buse de distribution pour amener les deux précurseurs de manière indépendante sans pré-mélange, de manière à ce qu'ils n'entrent en contact qu'au sortir de la buse à proximité du substrat. On a en effet pu constater que le rendement et la qualité de la couche s'en trouvaient améliorés.

En ce qui concerne le choix des précurseurs métalliques, on préfère dans le cadre de l'invention utiliser des halogénures, tout particulièrement des chlorures du type tétrachlorure de titane TiCl₄.

Quant au précurseur azoté, les amines qui se prêtent le mieux à la réaction de pyrolyse sont surtout les amines primaires et, dans une moindre mesure, les amines secondaires, présentant des radicaux alkyls ayant notamment de 1 à 4 atomes de carbone chacun. On peut citer la méthylamine (CH₃)NH₂, l'éthylamine (C₂H₅)NH₂, la diméthylamine (CH₃)₂NH, la tertiobutylamine (C₄H₉)NH₂ ou tout mélange d'au moins deux de ces amines. La méthylamine est particulièrement préférée, car elle présente un faible encombrement stérique, facteur qui semble favoriser une meilleure réaction sur la surface du substrat, un meilleur 〈〈 accrochage 〉〉 conduisant à des couches durables, de bonne qualité (uniformité d'épaisseur et absence de flou) et avec un bon rendement matière. Par ailleurs, le fait qu'elle soit peu 〈〈 chargée 〉〉 en carbone réduit tout risque d'encrassement de la buse de distribution par dépôt carboné. Cependant, les autres amines sont aussi intéressantes, en adaptant les conditions de dépôt.

Il semblerait en fait que la réaction de pyrolyse faisant intervenir le précurseur azoté s'effectue mieux et plus vite quand celui-ci présente des liaisons N-C qui présenteraient la propriété de se rompre très aisément sous l'effet de la chaleur, sans que celui-ci ne présente cependant un encombrement stérique trop important du fait de ses radicaux carbonés, d'où l'intérêt des amines primaires, où des liaisons NH subsistent. On a également constaté que, fort heureusement, l'utilisation d'amines porteuses de tels radicaux carbonés n'a pas entraîné la présence de traces détectables de carbone dans la couche de nitrure, ce que l'on aurait pu craindre, sachant que le carbone tend à abaisser les performances électriques des nitrures et à en altérer la couleur.

Le procédé selon l'invention permet également d'adapter la colorimétrie en transmission des substrats porteurs selon les besoins. Ainsi, le ou les précurseurs azotés peuvent être tous sous forme d'amine(s), de manière à garantir une couleur bleue en transmission. Une autre possibilité consiste à associer à ce ou ces précurseurs aminés d'autres précurseurs azotés, et tout particulièrement de l'ammoniac. En modulant la proportion relative entre amine(s) et ammoniac, on peut obtenir ainsi toutes les nuances de couleur en transmission comprises entre le jaune et le bleu en passant par le vert. On peut ainsi, par exemple, associer en des proportions relatives modulables, de la méthylamine et de l'ammoniac.

L'association des deux précurseurs d'azote pose d'autant moins de problèmes que les conditions opératoires peuvent être les mêmes pour introduire amines ou ammoniac.

De préférence, le procédé par pyrolyse selon l'invention s'effectue sur un substrat chauffé à une température comprise entre 400 et 700°C, notamment d'au moins 500°C, plus particulièrement d'environ 500 à 680°C, soit des températures rencontrées en partie aval de l'enceinte de flottage par exemple ou encore entre l'enceinte de flottage et l'étenderie.

Il s'est avéré efficace d'opérer avec un large excès des précurseurs azotés par rapport aux précurseurs métalliques, mais toute proportion relative entre les deux types de précurseurs est envisageable.

Le procédé selon l'invention s'applique tout particulièrement à la fabrication de vitrages multiples du type double-vitrage, afin de réduire dans les locaux qu'ils équipent la transmission d'énergie provenant du rayonnement solaire.

Les couches de nitrure ou oxynitrure de titane, grâce au choix des précurseurs selon l'invention, contiennent donc un taux résiduel en chlore tout-à-fait détectable, notamment dans une proportion atomique de 0,1 à 15%, notamment de 0,5 à 11%, par exemple d'environ 5+/-2% par rapport aux autres éléments. Et c'est donc ce taux de chlore qui apparaît pouvoir régler la couleur en transmission du substrat du jaune-brun vers les bleus. On peut le contrôler en sélectionnant des conditions de dépôt du type température, mais aussi en modulant la proportion respective d'ammoniac et d'amine lorsqu'on choisit de les associer.

On peut alors fabriquer la couche sans se placer dans des conditions draconiennes concernant l'atmosphère de dépôt, sans craindre d'obtenir des couleurs en transmission peu esthétiques, le chlore agissant en quelque sorte comme un 〈〈 correcteur de couleur 〉〉 si la couche contient des 〈〈 impuretés 〉〉 qui seraient susceptibles, seules, de modifier de manière non favorable la couleur en transmission.

En effet, si l'on dépose la couche en continu sur un ruban de verre d'une installation float, soit dans l'enceinte float, soit en aval de celle-ci, l'atmosphère de dépôt a plus ou moins tendance à contenir une certaine teneur en oxygène et en humidité. Il est aussi possible que l'oxygène du verre puisse migrer à la surface. Il existe diverses raisons de ce type qui peuvent expliquer le fait que la couche est déposée ou se retrouve finalement sous la forme d'un oxynitrure, avec une proportion atomique d'oxygène qui peut aller de 0,1 à 25% notamment de 4 à 14% par rapport aux autres éléments de la couche.

En fonction des conditions de dépôt, et notamment du taux plus ou moins significatif d'oxygène dans la couche qu'elles entraînent, on peut alors avantageusement, selon l'invention, ajuster le taux de chlore nécessaire pour garder à la couche une couleur bleutée en transmission.

Concrètement, l'invention permet donc de conserver au substrat une couleur bleutée en transmission très reproductible, quelle que soit la zone où est effectué le dépôt sur le ruban de la ligne float.

Il est à noter, en outre, que la fait que la couche contienne du chlore n'a pas de conséquence pénalisante si l'on effectue, après dépôt de la couche, un recuit en atmosphère neutre (N₂) ou réductrice (N₂/H₂) du substrat en verre. En effet, le chlore reste dans la couche et ne s'élimine pas au cours du traitement thermique, ce que l'on aurait pu craindre et ce qui aurait provoqué très vraisemblablement le 〈〈 retour 〉〉 de la couleur en transmission aux tonalités jaunes-bruns. On peut souligner également que les vitrages incorporant ces substrats à couche présentent une bonne durabilité.

Les couches de nitrure ou oxynitrure, notamment de titane, déposées sur des substrats de verre pour faire des vitrages ont de préférence une épaisseur comprise entre 15 et 80 nanomètres, notamment 20 à 50 nanomètres par exemple aux environs de 25 à 30 nanomètres, ceci afin de concilier propriétés de transparence et propriétés de réflexion / absorption des rayonnements solaires.

Un mode de réalisation préféré selon l'invention consiste à surmonter la couche à base de nitrure ou oxynitrure d'une couche en matériau diélectrique comme de l'oxyde, oxycarbure ou oxynitrure de silicium, ayant une épaisseur géométrique de préférence comprise entre 10 et 150 nm, notamment entre 40 et 80 nm, et un indice de réfraction de préférence compris entre 1,5 et 1,9, notamment entre 1,6 et 1,8.

L'intérêt d'une telle surcouche est tout d'abord colorimétrique : la couleur en transmission du vitrage dépend essentiellement des caractéristiques intrinsèques à la couche fonctionnelle absorbante qu'est la couche de nitrure ou d'oxynitrure. En revanche, une surcouche de caractéristiques appropriées en termes d'épaisseur et d'indice permet de régler, d'ajuster l'aspect en réflexion, notamment dans des couleurs agréables du type bleu, sans modifier ou perturber la couleur en transmission.

En outre, si la teneur en chlore et oxygène de la couche de nitrure ou d'oxynitrure n'est pas trop élevée, cette simple surcouche permet d'effectuer sur le substrat de verre des traitements thermiques à haute température en atmosphère ambiante, donc oxydante, du type bombage ou trempe, sans détériorer la couche de nitrure ou d'oxynitrure donc en préservant ses propriétés optiques, la surcouche la protégeant efficacement de l'oxydation.

On peut incorporer le substrat recouvert selon l'invention dans des vitrages de tous types, comme des vitrages multiples tels que les double-vitrages, qui présentent alors une couleur en transmission dans les bleus ou bleus-verts avec une longueur d'onde dominante en transmission comprise entre 475 et 520 nm. Les double-vitrages ont alors des transmissions lumineuses T_{L} comprises entre par exemple 40 et 60%, une transmission énergétique T_{E} comprise entre 35 et 55%. On peut alors obtenir des sélectivités, définies par le rapport T_{L}/T_{E}, supérieures à 1,1 notamment de l'ordre de 1,20 à 1,45.

Les détails et caractéristiques avantageuses de l'invention ressortent de la description détaillée suivante d'exemples de réalisation non limitatifs.

Ces exemples concernent le dépôt de couches de nitrure de titane d'environ 25 à 30 nanomètres d'épaisseur à l'aide d'un précurseur de titane de formule TiCl₄, sur un substrat de verre silico-sodo-calcique de 6 millimètres d'épaisseur.

Le dépôt a été effectué dans l'atmosphère d'une enceinte de flottage, soit un mélange H₂/N₂ à pression atmosphérique, par introduction simultanée à l'aide d'une buse de distribution standard du précurseur métallique et du précurseur azoté sur le substrat de verre.

Les précurseurs sont introduits dans la buse à pression et température ambiantes. On préfère prévoir dans la buse deux canaux distincts pour introduire chacun des deux précurseurs, précurseurs qui ne se mêlent qu'au sortir de celle-ci à proximité du verre. Pour s'assurer que la réaction/décomposition des précurseurs ne s'effectue que sur la surface du verre, et éviter ainsi tout dépôt de nitrure ou de dérivés carbonés sur les fentes de sortie des gaz de la buse, on préfère prévoir entre les deux canaux distincts un troisième canal générant un rideau de gaz inerte du type N₂ qui 〈〈 sépare 〉〉 encore pendant un à quelques millimètres les deux gaz précurseurs à la sortie de la buse.

Le gaz vecteur des deux précurseurs est 95 % de N₂ et 5 % de H₂ environ en volume, la vitesse de défilement du substrat de verre est d'environ 3 à 25 mètres par minute, notamment de 8 à 12 mètres par minute et la température du substrat est d'environ 500 à 700°C.

### EXEMPLES 1 et 2

Ce sont les exemples comparatifs : le précurseur azoté est de l'ammoniac en large excès, avec une proportion de 1 mole d'ammoniac pour environ 2.10⁻² mole de TiCl₄.

### EXEMPLES 3 et 4

Ce sont deux exemples selon l'invention : le précurseur azoté est de la méthylamine CH₃NH₂ dans la même proportion molaire par rapport à TiCl₄ qu'aux exemple 1 et 2.

Le tableau 1 ci-dessous regroupe pour chacun des deux exemples, différentes caractéristiques des substrats ainsi recouverts :les épaisseurs des couches en nanomètres e, les transmissions lumineuses T_{L} et énergétiques T_{E} en pourcentage %, les voleurs de longueur d'onde dominante en transmission lambda(t) en nanomètres et les valeurs de pureté de coloration en transmission p(t) en pourcentage % (valeurs mesurées selon l'illuminant D₆₅).

**TABLEAU 1**

| | **Exemple 1** | **Exemple 2** | **Exemple 3** | **Exemple 4** |
|---|---|---|---|---|
| e | 30 +/-5 | 25 +/-5 | 30 +/-5 | 25 +/-5 |
| T_{L} | 50 | 58 | 50 | 54 |
| T_{E} | 40 | 49 | 40 | 43 |
| Lambda (t) | 570 | 574 | 480-500 | 498 |
| p (t) | ≈ 10 | 11 | 3-10 | 5 |

Il est à noter par ailleurs que la couche de nitrure selon l'exemple 3 est plus conductrice que celle de l'exemple 1, et présente notamment une résistivité d'environ 2.10⁻³ ohm.cm.

Une analyse par microsonde électronique a été effectuée sur une couche obtenue conformément à l'exemple 1 mais d'une épaisseur de 100 nanomètres et sur une couche obtenue conformément à l'exemple mais d'une épaisseur de 92 nanomètres, ce type d'analyse donnant des résultats plus fiables sur des épaisseurs relativement importantes.

Il a été trouvé que, dans la couche obtenue conformément à l'exemple 1, le pourcentage atomique de chlore est d'environ 2 % tandis qu'il est d'environ 11 % dans la couche obtenue conformément à l'exemple 2.

L'analyse n'a pas détecté de carbone dans les deux couches.

### EXEMPLES 5 à 7

Ce sont trois exemples selon l'invention où l'on utilise comme précurseur azoté un mélange d'ammoniac et de méthylamine, avec toujours du TiCl₄ comme précurseur de titane, dans des proportions molaires différentes, et notamment une proportion molaire entre les deux précurseurs azotés allant de 25/75 à 75/25.

Dans l'exemple 5, on utilise environ 0,5 mole de NH₃ et 0,5 mole de CH₃NH₂ pour 2.10⁻² mole de TiCl₄.

Dans l'exemple 6, on utilise environ 0,25 mole de NH₃ et 0,75 mole de CH₃NH₂ pour 2.10⁻² Mole de TiCl₄.

Dans l'exemple 7, on utilise environ 0,75 mole de NH₃ et 0,25 mole de CH₃NH₂ pour 2.10⁻² Mole de TiCl₄.

Les couches déposées ont une épaisseur d'environ 25 +/-5 nanomètres. Des couches nettement plus épaisses ont également été faites afin de faire des analyses par microsonde électronique fiables. Le tableau 2 ci-dessous regroupe pour chacun des exemples la longueur d'onde dominante en transmission lambda (t) en nanomètres, la pureté de coloration correspondante p(t) en pourcentage et la proportion atomique de chlore résiduel par rapport aux autres éléments de la couche en pourcentage % Cl.

**TABLEAU 2**

| | Lambda (t) | p(t) | % Cl |
|---|---|---|---|
| Exemple 5 | 520 | 6 | 6 |
| Exemple 6 | 504 | 5 | 8 |
| Exemple 7 | 550 | 6 | 4 |

La proportion atomique d'oxygène de ces trois couches est par ailleurs comprise dans une gamme de 4 à 11%. Cette proportion est en fait assez variable et sa quantification par analyse reste relativement approximative à cause de la présence du substrat de verre qui en contient beaucoup. Elle est faible, voire très faible, si le dépôt s'effectue dans l'enceinte du bain float, elle sera plus élevée si le dépôt se fait après l'enceinte. Moduler le taux de chlore permet de 〈〈 compenser 〉〉 des variations de taux d'oxygène pour maintenir constant l'aspect colorimétrique en transmission du substrat.

### EXEMPLES 8 à 11

On dépose sur des substrats recouverts selon l'exemple 4 précédent une surcouche en SiO₂/SiOₓC_{y} de manière connue, notamment par une technique de pyrolyse en phase gazeuse à partir de silane et d'éthylène. On se rapportera pour plus de détails notamment à l'enseignement de la demande de brevet EP-A-0 518 755.

Les surcouches ont, pour ces quatres exemples, toutes un indice de réfraction d'environ 1,7 mais des épaisseurs géométriques variables. Une fois les substrats recouverts des deux couches, on les monte en double-vitrages en les associant à un autre substrat de verre silico-sodo-calcique de 6 millimètres d'épaisseur, les couches minces se trouvant de préférence en face 2 une fois le double-vitrage monté dans un bâtiment (les faces d'un vitrage multiple sont conventionnellement numérotées à partir de la face la plus extérieure au bâtiment).

Le tableau 3 ci-dessous regroupe pour chacun des quatre double-vitrages les valeurs d'épaisseur en nanomètres de surcouches SiOₓC_{y} e(SiOₓC_{y}), les valeurs de T_{L}, T_{E} , lambda (t) et p(t) avec les mêmes significations que précédemment, ainsi que facteur solaire (FS) qui est le rapport entre l'énergie totale entrant dans le local à travers le vitrage et l'énergie solaire incidente, facteur mesuré selon la norme ISO 9050.

**TABLEAU 3**

| | **e(SiO**_{**x**}**C**_{**y**}**)** | **FS** | **TE** | **TL** | **Lambda (t)** | **p(t)** |
|---|---|---|---|---|---|---|
| Exemple 8 | 50 +/-2 | 0,44 | 37 | 51 | 499 | 3 |
| Exemple 9 | 53 +/-2 | 0,44 | 37 | 51 | 492 | 4 |
| Exemple 10 | 57 +/-2 | 0,44 | 37 | 50 | 493 | 3 |
| Exemple 11 | 60 +/-2 | 0,46 | 39 | 52 | 486 | 7 |

Le tableau 4 ci-dessous regroupe, toujours pour chacun des double-vitrages :
- les valeurs liées à l'aspect en réflexion extérieure des vitrages, avec la réflexion lumineuse extérieure R_{L ext} en pourcentage, la longueur d'onde dominante Lambda (Rₑₓₜ) et la pureté p (Rₑₓₜ) qui y sont associées,
- les valeurs liées à l'aspect en réflexion intérieure avec la réflexion lumineuse intérieure R_{L int}, et les valeurs de longueur d'onde dominante Lambda (Rᵢₙₜ) et de pureté et p (Rᵢₙₜ) qui y sont associées.

L'aspect en réflexion dite extérieure correspond à celui qu'observe une personne en regardant le vitrage monté en façade, de l'extérieur. L'aspect en réflexion dite intérieure correspond à celui qu'observe une personne en regardant le vitrage de l'intérieur du local, lorsqu'il fait sombre à l'extérieur et que c'est le local qui est équipé de moyens d'éclairage.

**TABLEAU 4**

| | **R**_{**Lext**} | **Lambda (R**_{**ext**}**)** | **p(R**_{**ext**}**)** | **R**_{**Lint**} | **Lambda (R**_{**int**}**)** | **p(R**_{**int**}**)** |
|---|---|---|---|---|---|---|
| Exemple 8 | 24 | 489 | 7 | 15 | 489 | 5 |
| Exemple 9 | 23 | 497 | 3 | 11 | 493 | 3 |
| Exemple 10 | 25 | 534 | 2 | 11 | 503 | 2 |
| Exemple 11 | 26 | 558 | 5 | 13 | 488 | 4 |

De ces données peuvent être tirées les conclusions suivantes : le dépôt de couches de nitrure à partir de précurseurs aminés permet d'obtenir des vitrages bleus en transmission, puisque d'après le tableau 1, la longueur d'onde dominante en transmission des vitrages des exemples 3 et 4 se situe dans la gamme 475-500 nm, tandis que les vitrages des exemples 1 et 2 obtenus à partir d'ammoniac conservent une forte coloration jaune (longueur d'onde dominante de 570-575 nm).

Par ailleurs, la couleur bleue en transmission obtenue selon l'invention est associée à une valeur de pureté p(t) faible, notamment de l'ordre de 5 %, d'où une nuance atténuée, "lavée de blanc" et esthétique.

Le procédé en lui-même reste très simple, puisque les précurseurs sous forme gazeuse sont introduits dans la buse à pression et température ambiantes, sans nécessiter un contrôle très fin du taux d'humidité, d'oxygène ou d'impuretés résiduelles.

L'absence de pré-mélange des précurseurs dans la buse est un point favorable qui diminue fortement le risque de formation de composés pulvérulents avant la réaction de dépôt.

Concernant les caractéristiques intrinsèques des couches de nitrure, les couches de nitrure selon l'invention présentent d'après les analyses par microsonde un taux de chlore plus important que les couches obtenues à partir d'ammoniac, dont l'effet était imprévisible. C'est ce taux supérieur de chlore qui permet d'obtenir cette couleur bleutée en transmission très esthétique, et d'éviter d'obtenir des couleurs jaunes peu agréables dues au fait que les couches de nitrure déposées ne sont pas d'une pureté extrême, et peuvent contenir notamment un peu d'oxygène.

Par contre, on n'enregistre pas de traces carbonées détectables dans les couches selon l'invention, ce qui est très avantageux.

Le fait que ces couches présentent en outre une conductivité électrique plus élevée, particulièrement lorsqu'elles ont une épaisseur d'au moins 50 nm, traduit une qualité supérieure et permet d'obtenir des valeurs de facteur solaire plus faibles dans le cas de montages de ce type de couche à l'intérieur d'un vitrage isolant.

Il va de soi que l'on peut faire varier l'épaisseur des couches de nitrure afin de modifier les valeurs de transmission lumineuse des vitrages qui les portent suivant les besoins. Mais on conserve cet aspect bleuté en transmission si l'on modifie un peu l'épaisseur de la couche (voir les exemples 3 et 4), ce qui est très avantageux. Cependant la sélectivité, soit le rapport T_{L}/T_{E}, reste à peu près constante de l'ordre de 1,20 à 1,45, ce qui garde au vitrage de bonnes performances anti-solaires quel que soit le niveau de transparence requis.

Des exemples 3, 4 et 8 à 11, on constate que la couleur en transmission est inhérente en grande partie à la couche de nitrure ou d'oxynitrure elle-même. Ajouter d'autres couches minces non absorbantes telles qu'une surcouche d'oxyde permet alors de garder cet aspect bleuté en transmission tout en adaptant l'aspect en réflexion de vitrages. Ainsi la longueur d'onde dominante en transmission des vitrages à surcouche des exemples 8 à 11 reste dans la gamme des 475-500 nm. Par contre, l'aspect en réflexion extérieure, selon l'épaisseur de la surcouche, peut varier à volonté du bleu (exemple 8) au jaune-vert (exemple 11).

Des exemples 5 à 7, on voit que moduler la proportion entre ammoniac et amine permet de faire varier le taux de chlore résiduel ainsi que la couleur en transmission, qui se rapproche du jaune à forte proportion d'ammoniac (exemple 7) ou du bleu à forte proportion d'amine (exemple 6). Là encore, il y a donc une possiblité de choix maitrisé de l'aspect en transmission. Il est à noter que l'on peut aussi régler le taux de chlore résiduel d'autres façons, en gardant un précurseur azoté 100% sous forme d'amine mais en jouant sur les conditions de dépôt du type température, etc... (on a en effet également tendance à diminuer le taux de chlore en augmentant la température de dépôt).

En conclusion, le procédé selon l'invention offre la possibilité de contrôler la colorimétrie du vitrage, aussi bien en réflexion qu'en transmission, et est particulièrement souple de mise en oeuvre. Il permet ainsi de 〈〈 restituer 〉〉 à la couche de nitrure métallique des caractéristiques colorimétriques très satisfaisantes, avec une technique (et des conditions) de dépôt beaucoup plus simples et économiques que les techniques de dépôt du type pulvérisation cathodique.

## Revendications

1. Procédé de dépôt par pyrolyse en phase gazeuse d'une couche à base de nitrure ou oxynitrure de titane, sur un substrat transparent, notamment en verre, caractérisé en ce qu'il consiste à amener simultanément au contact du substrat porté à haute température au moins un précurseur métallique et au moins un précurseur azoté sous forme d'amine dans un rapport de l'ordre de 2%, la couche ainsi obtenue confèrant audit substrat une couleur en transmission dans la gamme des bleus ou bleus-verts.

2. Procédé selon la revendication 1, caractérisé en ce que le dépôt s'effectue sur un substrat constitué d'un ruban de verre float, notamment dans l'enceinte du bain de flottage.

3. Procédé selon l'une des revendications précédentes, caractérisé en ce que le dépôt s'effectue avec une seule buse de distribution pour projeter les deux types de précurseurs, sans mélange préalable, ceux-ci ne rentrant en contact qu'au sortir de la buse à proximité du substrat.

4. Procédé selon l'une des revendications précédentes, caractérisé en ce que le précurseur de titane est un halogénure, notamment du tétrachlorure de titane TiCl₄.

5. Procédé selon l'une des revendications précédentes, caractérisé en ce que le précurseur azoté sous forme d'amine est une amine primaire ou secondaire, notamment à radicaux alkyls de 1 à 4 atomes de carbone chacun.

6. Procédé selon la revendication 5, caractérisé en ce que l'amine est de la méthylamine (CH₃)NH₂, de l'éthylamine (C₂H₅)NH₂, de la diméthylamine (CH₃)₂NH, de la tertiobutylamine (C₄H₉)(NH₂) ou un mélange de deux au moins de celles-ci.

7. Procédé selon l'une des revendications précédentes, caractérisé en ce que tous les précurseurs azotés sont sous forme d'une amine ou d'un mélange d'amines.

8. Procédé selon l'une des revendications 1 à 6, caractérisé en ce qu'on associe au(x) précurseur(s) azoté(s) sous forme d'amine(s) un précurseur azoté sous forme d'ammoniac, avec par exemple une association du type méthylamine et ammoniac.

9. Procédé selon la revendication 8, caractérisé en ce qu'on module la proportion relative entre précurseur(s) azoté(s) sous forme d'amine(s) et précurseur azoté sous forme d'ammoniac afin de nuancer la couleur en transmission conférée par la couche de nitrure ou d'oxynitrure au substrat, notamment entre le bleu et le vert.

10. Procédé selon l'une des revendications précédentes, caractérisé en ce que le substrat est à une température comprise entre 400 et 700°C, notamment supérieure à 500°C, plus particulièrement comprise entre 500 à 680°C.

11. Procédé selon l'une des revendications précédentes, caractérisé en ce qu'on opère avec un excès de précurseurs azotés par rapport au(x) précurseur(s) métallique(s).

12. Application du procédé selon l'une des revendications précédentes à la fabrication de vitrages, notamment de vitrages multiples type double-vitrages, pour la protection vis-à-vis des rayonnements solaires.

13. Substrat transparent recouvert d'une couche à base de nitrure ou oxynitrure de titane obtenue conformément au procédé selon l'une des revendications 1 à11, caractérisé en ce que la couche à base de nitrure ou d'oxynitrure de titane contient du chlore dans une proportion atomique de 0,1 à 25%, notamment de 4 à 14% par rapport aux autres éléments de la couche.

14. Substrat transparent recouvert d'une couche à base d'oxynitrure de titane obtenue conformément au procédé selon l'une des revendications 1 à 11, caractérisé en ce que la couche en oxynitrure contient de l'oxygène dans une proportion atomique d'oxygène de 0,1 à 25%, notamment de 4 à 14% par rapport aux autres éléments de la couche.

15. Substrat transparent recouvert d'une couche à base de nitrure ou d'oxynitrure de titane, caractérisé en ce que ladite couche contient du chlore dans une proportion atomique de 0,1 à 15%, de préférence de 0,5 à 11%.

16. Substrat selon la revendication 15, caractérisé en ce que ladite couche est en oxynitrure contenant du chlore, et en outre de l'oxygène dans une proportion atomique de 0,1 à 25% et notamment de 4 à 14% par rapport aux autres éléments de la couche.

17. Substrat selon l'une des revendications 13 à 16, caractérisé en ce que l'épaisseur géométrique de la couche à base de nitrure ou d'oxynitrure de titane est comprise entre 15 et 80 nm, notamment entre 20 et 50 nm.

18. Substrat selon l'une des revendications 13 à17, caractérisé en ce que la couche à base de nitrure ou d'oxynitrure de titane est surmontée d'une couche en matériau diélectrique comme de l'oxyde, oxycarbure et/ou oxynitrure de silicium, ayant une épaisseur géométrique comprise entre 10 et 150 nm, notamment entre 40 et 80 nm et un indice de réfraction de préférence comprise entre 1,5 et 1,9, notamment 1,6 à 1,8.

19. Double-vitrage incorporant le substrat selon l'une des revendications 13 à 18, caractérisé en ce qu'il présente une couleur en transmission dans les bleus ou bleus-verts, avec une longueur d'onde dominante en transmission comprise entre 475 et 520 nm.

20. Double-vitrage selon la revendication 19, caractérisé en ce qu'il présente un rapport T_{L}/T_{E} supérieur à 1,1, notamment de l'ordre de 1,20 à 1,45.

## Claims

1. Process for the deposition by gas phase pyrolysis of a titanium nitride or oxynitride-based layer on a transparent substrate, more particularly of glass, characterized in that it consists of simultaneously bringing into contact with the substrate raised to a high temperature at least one metal precursor and at least one nitrogen precursor in amine form in a ratio of approximately 2%, the thus obtained layer giving said substrate a colour in transmission in the blue or blue-green range.

2. Process according to claim 1, characterized in that deposition takes place on a substrate constituted by a float glass ribbon, particularly in the enclosure of the float bath.

3. Process according to one of the preceding claims, characterized in that deposition takes place with a single distribution nozzle for spraying the two types of precursors, without prior mixing, said precursors only coming into contact on leaving the nozzle in the vicinity of the substrate.

4. Process according to one of the preceding claims, characterized in that the titanium precursor is a halide, particularly titanium tetrachloride TiCl₄.

5. Process according to one of the preceding claims, characterized in that the nitrogen precursor in amine form is a primary or secondary amine, particularly having alkyl radicals with 1 to 4 carbon atoms each.

6. Process according to claim 5, characterized in that the amine is methyl amine (CH₃)NH₂, ethyl amine (C₂H₅)NH₂, dimethyl amine (CH₃)₂NH, tert. butyl amine (C₄H₉)NH₂) or a mixture of at least two of these.

7. Process according to one of the preceding claims, characterized in that all the nitrogen precursors are in the form of an amine or a mixture of amines.

8. Process according to one of the claims 1 to 6, characterized in that with the nitrogen precursor or precursors in amine form is associated a nitrogen precursor in the form of ammonia, e.g. with an association of the methyl amine and ammonia type.

9. Process according to claim 8, characterized in that the relative proportion between the nitrogen precursor or precursors in amine form and the nitrogen precursor in ammonia form is varied in order to shade the colour in transmission given by the nitride or oxynitride layer to the substrate, particularly between blue and green.

10. Process according to one of the preceding claims, characterized in that the substrate is at a temperature between 400 and 700°C, particularly above 500°C and more especially between 500 and 680°C.

11. Process according to one of the preceding claims, characterized in that working takes place with an excess of nitrogen precursors compared with the metal precursor or precursors.

12. Application of the process according to one of the preceding claims to the manufacture of glazings, particularly multiple glazings of the double glazing type for protection against solar radiation.

13. Transparent substrate covered with a titanium nitride or oxynitride-based layer obtained according to the process of one of the claims 1 to 11, characterized in that the titanium nitride or oxynitride-based layer contains chlorine in an atomic proportion of 0.1 to 25%, particularly 4 to 14% compared with the other elements of the layer.

14. Transparent substrate covered with a titanium oxynitride layer obtained according to the process of one of the claims 1 to 11, characterized in that the oxynitride layer contains oxygen in an atomic proportion of oxygen of 0.1 to 25%, particularly 4 to 14% compared with the other elements of the layer.

15. Transparent substrate covered with a titanium nitride or oxynitride-based layer, characterized in that said layer contains chlorine in an atomic proportion of 0.1 to 15%, preferably 0.5 to 11%.

16. Substrate according to claim 15, characterized in that said layer is of oxynitride containing chlorine and also oxygen in an atomic proportion of 0.1 to 25% and more particularly 4 to 14% compared with the other elements of the layer.

17. Substrate according to one of the claims 13 to 16, characterized in that the geometrical thickness of the titanium nitride or oxynitride-based layer is between 15 and 80 nm, particularly between 20 and 50 nm.

18. Substrate according to one of the claims 13 to 17, characterized in that the titanium nitride or oxynitride-based layer is surmounted by a dielectric material layer, such as silicon oxide, oxycarbide and/or oxynitride having a geometrical thickness between 10 and 150 nm, particularly between 40 and 80 nm and a refractive index preferably between 1.5 and 1.9, particularly between 1.6 and 1.8.

19. Double glazing incorporating the substrate according to one of the claims 13 to 18, characterized in that it has a colour in transmission in the blue or blue-green range, with a dominant wavelength in transmission between 475 and 520 nm.

20. Double glazing according to claim 19, characterized in that it has a T_{L}/T_{E} ratio above 1.1 and in particular approximately 1.20 to 1.45.

## Patentansprüche

1. Verfahren zum Aufbringen einer Schicht auf der Basis von Titannitrid oder Titannitridoxid auf ein transparentes Substrat, insbesondere Glas, durch Pyrolyse aus der Gasphase, **dadurch gekennzeichnet, daß** es darin besteht, mindestens einen Metall-Vorläufer und mindestens einen stickstoffhaltigen Vorläufer in Form eines Amins mit einem Anteil von etwa 2 % gleichzeitig mit dem auf hohe Temperatur gebrachten Substrat in Berührung zu bringen, wobei die so erhaltene Schicht dem Substrat in Durchsicht eine Farbe im blauen oder blaugrünen Bereich verleiht.

2. Verfahren nach Anspruch 1, **dadurch gekennzeichnet, daß** der Abscheidevorgang insbesondere in der Wanne eines Floatbades auf einem Substrat erfolgt, das aus einem Floatglasband besteht.

3. Verfahren nach einem der vorhergehenden Ansprüche, **dadurch gekennzeichnet, daß** der Abscheidevorgang mit einer einzigen Verteilerdüse erfolgt, um ohne vorheriges Vermischen die beiden Vorläufer-Arten aufzusprühen, die erst beim Verlassen der Düse in der Nahe des Substrats miteinander in Kontakt kommen.

4. Verfahren nach einem der vorhergehenden Ansprüche, **dadurch gekennzeichnet, daß** der Titanvorläufer ein Halogenid und insbesondere Titantetrachlorid, TiCl₄, ist.

5. Verfahren nach einem der vorhergehenden Ansprüche, **dadurch gekennzeichnet, daß** der stickstoffhaltige Vorläufer in Form eines Amins ein primäres oder sekundäres Amin, insbesondere mit Alkylresten mit jeweils 1 bis 4 Kohlenstoffatomen, ist.

6. Verfahren nach Anspruch 5, **dadurch gekennzeichnet, daß** das Amin Methylamin, (CH₃)NH₂, Ethylamin, (C₂H₅)NH₂, Dimethylamin, (CH₃)₂NH, *tert*.-Butylamin, (C₄H₉)(NH₂) oder ein Gemisch aus mindestens zwei davon ist.

7. Verfahren nach einem der vorhergehenden Ansprüche, **dadurch gekennzeichnet, daß** alle stickstoffhaltigen Vorläufer in Form eines Amins oder eines Amingemisches vorliegen.

8. Verfahren nach einem der Ansprüche 1 bis 6, **dadurch gekennzeichnet, daß** dem/den stickstoffhaltigen Vorläufer/n in Form von Amin/en ein stickstoffhaltiger Vorläufer in Form von Ammoniak beigemischt wird, beispielsweise eine Kombination wie Methylamin und Ammoniak.

9. Verfahren nach Anspruch 8, **dadurch gekennzeichnet, daß** das Verhältnis zwischen stickstoffhaltigem/stickstoffhaltigen Vorläufer/n in Form von Amin/en und stickstoffhaltigem Vorläufer in Form von Ammoniak verändert wird, um den Farbton in Durchsicht, der dem Substrat von der Nitrid- bzw. Nitridoxidschicht verliehen wird, insbesondere zwischen Blau und Grün zu nuancieren.

10. Verfahren nach einem der vorhergehenden Ansprüche, **dadurch gekennzeichnet, daß** die Temperatur des Substrats 400 bis 700 °C, insbesondere mehr als 500 °C und noch spezieller 500 bis 680 °C beträgt.

11. Verfahren nach einem der vorhergehenden Ansprüche, **dadurch gekennzeichnet, daß** man in bezug auf den/die Metall-Vorläufer mit einem Überschuß an stickstoffhaltigen Vorläufern arbeitet.

12. Anwendung des Verfahrens nach einem der vorhergehenden Ansprüche auf die Herstellung von Verglasungen, insbesondere Mehrfachverglasungen wie Doppelverglasungen, für den Sonnenschutz.

13. Transparentes Substrat, welches mit einer Schicht auf der Basis von Titannitrid bzw. Titannitridoxid überzogen ist, die gemäß dem Verfahren nach einem der Ansprüche 1 bis 11 erhalten worden ist, **dadurch gekennzeichnet, daß** die Schicht auf der Basis von Titannitrid bzw. Titannitridoxid Chlor mit einem Atomanteil von 0,1 bis 25 % und insbesondere von 4 bis 14 %, bezogen auf die anderen Elemente der Schicht, enthält.

14. Transparentes Substrat, welches mit einer Schicht auf der Basis von Titannitridoxid überzogen ist, die gemäß dem Verfahren nach einem der Ansprüche 1 bis 11 erhalten worden ist, **dadurch gekennzeichnet, daß** die Nitridoxidschicht Sauerstoff mit einem Atomanteil von 0,1 bis 25 % und insbesondere von 4 bis 14 %, bezogen auf die anderen Elemente der Schicht, enthält.

15. Transparentes Substrat, welches mit einer Schicht auf der Basis von Titannitrid bzw. Titannitridoxid überzogen ist, **dadurch gekennzeichnet, daß** die Schicht Chlor mit einem Atomanteil von 0,1 bis 15 % und vorzugsweise 0,5 bis 11 % enthält.

16. Substrat nach Anspruch 15, **dadurch gekennzeichnet, daß** die Nitridoxidschicht Chlor und außerdem Sauerstoff mit einem Atomanteil von 0,1 bis 25 % und insbesondere 4 bis 14 %, bezogen auf die anderen Elemente der Schicht, enthält.

17. Substrat nach einem der Ansprüche 13 bis 16, **dadurch gekennzeichnet, daß** die geometrische Dicke der Schicht auf der Basis von Titannitrid bzw. Titannitridoxid 15 bis 80 nm und insbesondere 20 bis 50 nm beträgt.

18. Substrat nach einem der Ansprüche 13 bis 17, **dadurch gekennzeichnet, daß** die Schicht auf der Basis von Titannitrid bzw. Titannitridoxid von einer Schicht aus einem dielektrischem Material wie Siliciumoxid, -carbidoxid und/oder -nitridoxid bedeckt ist, deren geometrische Dicke 10 bis 150 nm und insbesondere 40 bis 80 nm und deren Brechungsindex 1,5 bis 1,9 und insbesondere 1,6 bis 1,8 beträgt.

19. Doppelverglasung, welche das Substrat nach einem der Ansprüche 13 bis 18 enthält, **dadurch gekennzeichnet, daß** ihre Farbe in Durchsicht blau oder blaugrün mit einer dominierenden Wellenlänge in Transmission von 475 bis 520 nm ist.

20. Doppelverglasung nach Anspruch 19, **dadurch gekennzeichnet, daß** sie ein Verhältnis von T_{L}/T_{E} von über 1,1 und insbesondere von etwa 1,20 bis 1,45 aufweist.
